(19) Europäisches Patentamt
European Patent Office
Office européen des brevets

(11) **EP 3 196 951 B1**

(12) **EUROPÄISCHE PATENTSCHRIFT**

(45) Veröffentlichungstag und Bekanntmachung des Hinweises auf die Patenterteilung:
**14.11.2018 Patentblatt 2018/46**

(51) Int Cl.:
***H01L 35/34*** *(2006.01)* ***B22F 3/105*** *(2006.01)*

(21) Anmeldenummer: **16152219.8**

(22) Anmeldetag: **21.01.2016**

(54) **RATIONELLES VERFAHREN ZUR PULVERMETALLURGISCHEN HERSTELLUNG THERMOELEKTRISCHER BAUELEMENTE**

RATIONAL METHOD FOR THE POWDER METALLURGICAL PRODUCTION OF THERMOELECTRIC COMPONENTS

PROCEDE RATIONNEL DE PRODUCTION METALLURGIQUE PULVERULENTE DE COMPOSANTS THERMOELECTRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.07.2017 Patentblatt 2017/30**

(73) Patentinhaber: **Evonik Degussa GmbH**
**45128 Essen (DE)**

(72) Erfinder:
• **HOCH, Sacha**
  **44797 Bochum (DE)**
• **KERN, Magdalena**
  **63755 Alzenau (DE)**
• **STENNER, Patrik**
  **63452 Hanau (DE)**
• **BUSSE, Jens**
  **44879 Bochum (DE)**
• **GIESSELER, Mareike**
  **63477 Maintal (DE)**
• **DEIS, Wolfgang**
  **69115 Heidelberg (DE)**
• **RAJIC, Zeljko**
  **71336 Waibingen (DE)**

(56) Entgegenhaltungen:
EP-A2- 0 880 184        WO-A1-2015/043824
DE-A1-102012 205 087    JP-A- 2002 076 451
JP-A- 2003 332 644      US-B1- 6 297 441

**Beschreibung**

Die Erfindung betrifft ein Verfahren zur pulvermetallurgischen Herstellung eines thermoelektrischen Bauelements oder zumindest eines Halbzeugs desselben.

Ein thermoelektrisches Bauelement ist ein Energiewandler, welcher thermische Energie unter Ausnutzung des von Peltier und Seebeck beschriebenen thermoelektrischen Effekts in elektrische Energie umsetzt. Da der thermoelektrische Effekt reversibel ist, kann jedes thermoelektrisches Bauelement auch zur Umsetzung von elektrischer Energie in thermische Energie genutzt werden: so genannte Peltier-Elemente dienen unter elektrischer Leistungsaufnahme zum Kühlen bzw. Wärmen von Objekten. Peltier-Elemente verstehen sich daher auch als thermoelektrische Bauelemente im Sinne der Erfindung. Thermoelektrische Bauelemente, die zur Umwandlung von thermischer Energie in elektrische Energie dienen, werden oft als thermoelektrische Generatoren (TEG) bezeichnet.

Technisch ausgeführte thermoelektrische Bauelemente umfassen mindestens ein aus zwei Thermoschenkeln gebildetes Thermopaar aus thermoelektrisch aktivem Material und eine das Thermopaar tragende und umschließende, elektrisch nach außen hin isolierende Hülle.

In der Literatur ist eine Vielzahl von thermoelektrisch aktiven Materialien beschrieben. Für den kommerziellen Einsatz eignen sich beispielsweise Legierungen aus der Klasse der halbleitenden Wismuttelluride (insbesondere mit zusätzlichen Anteilen von Selen und/oder Antimon) aus welchen sich - einerseits p-leitend und andererseits n-leitend dotiert - ein Thermopaar aufbauen lässt.

Weitere thermoelektrisch aktive Stoffklassen sind: Halb-Heusler-Materialien, verschiedene Silizide (insbesondere Magnesium, Eisen), verschiedene Telluride (Blei, Zinn, Lanthan, Antimon, Silber), Skutterudite, verschiedene Antimonide (Zink, Cer, Eisen, Ytterbium, Mangan, Cobalt, Wismut; teilweise auch als Zintl-Phasen bezeichnet), TAGS, Siliziumgermanide, Clathrate (insbes. auf Germanium-Basis). Neben diesen Halbleitermaterialien lassen sich thermoelektrische Bauelemente auch aus Kombinationen der meisten gewöhnlichen Metalle herstellen, wie dies z. B. bei handelsüblichen Thermoelementen zur Temperaturmessung der Fall ist, z. B. Ni-CrNi. Jedoch sind die so erzielbaren sog. Gütezahlen (thermoelektrische "Wirkungsgrade") deutlich geringer als bei den genannten Halbleitermaterialien.

Konventionelle thermoelektrische Bauelemente bestehen üblicherweise aus massiven Quadern aus thermoelektrisch aktiven Halbleitern sowie harten, zumeist keramischen, elektrisch isolierenden Umhüllungen. Soweit massive Quader eingesetzt werden, werden diese aus massiven Ingots herausgesägt.

Da Ingots oft Fehlstellen oder Lunker enthalten, ist es üblich, diese erst zu Pulver zu vermahlen und das Pulver zu einem hochverdichteten Wafer zu sintern. Aus dem dichten, hohlraumarmen Wafer werden dann nach Bedarf quaderförmige TE-Schenkel herausgesägt.

Aus der WO2008061823A1 ist es bekannt, ein Halbzeug für ein thermoelektrisches Bauelement herzustellen, indem in ein flächiges poröses Substrat thermoelektrisches Material als Pulver eingebracht wird. Die Thermoschenkel des hergestellten Bauelements erstrecken sich senkrecht zur Substratebene.

Ein weiteres pulvermetallurgisches Verfahren zur Herstellung von thermoelektrischen Bauelementen ist aus der DE102012205087A1 bekannt. Die Verpressung des pulverförmig bereitgestellten Aktivmaterials erfolgt innerhalb der Löcher einer perforierten Matrize, die zu einem Bestandteil des hergestellten thermoelektrischen Bauelements wird, nämlich zum Substrat.

Der Nachteil dieses Verfahren ist darin zu sehen, dass diese Matrize notwendigerweise aus einem thermisch und elektrisch isolierenden Werkstoff bestehen muss, da sie als Substrat in dem TEG verbleibt. Zugleich muss die Matrize während des Pressens der Grünlinge hohe mechanische Belastungen ertragen, was die Wahl des thermisch und elektrisch isolierenden Substratmaterials einschränkt.

Ein verbessertes Verfahren zur pulvermetallurgischen Herstellung thermoelektrischer Bauelemente ist aus der WO2015/043824A1 bekannt. Bei diesem Verfahren wird das pulverförmige Aktivmaterial in einer außerhalb des Substrats angeordneten Form zu Grünlingen verpresst, die Grünlinge aus der Form heraus in vorgesehene Löcher des Substrats eingedrückt und darin zu Thermoschenkeln versintert.

Nachteil dieses Verfahrens ist, dass die außerhalb des Substrats angeordnete Form, in der das Aktivmaterial zu den Grünlingen verpresst wird, fluchtend mit den Löchern des Substrats, in welche die Grünlinge eingepresst werden, angeordnet werden muss. Für diese Ausrichtung und für die Überführung der Grünlinge aus der Form in das Substrat ist eine Sondermaschine erforderlich, welche eigens für diesen Zweck entwickelt und hergestellt werden muss. Dadurch steigen die Investitionskosten für eine nach diesem Verfahren produzierende Fertigungsstraße erheblich. Darüber hinaus unterliegen die Grünlinge einem Sinterschwund, also einer Verringerung des Volumens im Zuge des Sintervorgangs. Dadurch verkürzen sich die Thermoschenkel innerhalb des Substrats, wodurch diese nur noch schwierig zu kontaktieren sind. In der Regel muss überstehendes Substratmaterial abgeschliffen werden, um einen bündigen Abschluss der Thermoschenkel mit der Oberfläche des Substrats zu erreichen, was die Voraussetzung für eine sichere elektrische Kontaktierung ist. Dieser Prozessschritt erhöht die Fertigungskosten.

Ein weiterer grundsätzlicher Nachteil des in WO2015/043824A1 beschriebenen Verfahrens ist, dass es keine individuelle Gewichtskontrolle der Schenkel erlaubt. Dies erschwert die Einhaltung enger Spezifikationsgrenzen der Homogenität der Schenkeldichte.

Aus der US 6,297,441 B1 ist ein Verfahren zur Herstellung eines thermoelektrischen Bauelements bekannt, wobei Bereitstellen von pulverförmigem, thermoelektrisch aktivem Aktivmaterial und Verpressen des Aktivmaterials zu Grünlingen ausgeführt wird.

Ausgehend von diesem Stand der Technik liegt der Erfindung die Aufgabe zu Grunde, ein pulverbasiertes Verfahren zur Herstellung eines thermoelektrischen Bauelements bzw. eines entsprechenden Halbzeugs anzugeben, welches mit standardisierten Maschinen durchgeführt werden kann, um die Investitionskosten zu senken und die Prozessstabilität zu erhöhen. Zudem sollen Nachbearbeitungsschritte zur Egalisierung von Substrat und Thermoschenkel bestenfalls vermieden werden. Zur Erleichterung der Qualitätssicherung soll eine Gewichtskontrolle der einzelnen Thermoschenkel bzw. deren Grünlinge möglich sein.

Gelöst wird diese Aufgabe durch ein Verfahren mit den folgenden Schritten:

a) Bereitstellen eines im Wesentlichen ebenen Substrats aus einem elektrisch und thermisch isolierenden Substratmaterial, durch welches sich im Wesentlichen senkrecht zur Substratebene ausgerichtete Durchgangslöcher erstrecken;

b) Bereitstellen von pulverförmigem, thermoelektrisch aktivem Aktivmaterial;

c) Verpressen des Aktivmaterials zu Grünlingen, wobei das Verpressen in einer von dem Substrat verschiedenen Form erfolgt;

d) Einsetzen der Grünlinge in die Durchgangslöcher des Substrats, sodass innerhalb eines jeden Durchgangslochs entlang dessen Achse sich je ein Grünling durch das Substrat hindurch erstreckt;

e) Anordnen des Substrats mit den darin eingesetzten Grünlingen zwischen zwei im Wesentlichen ebenen Elektroden, sodass beide Elektroden und das Substrat im Wesentlichen parallel zueinander ausgerichtet sind;

f) Kontaktieren der Stirnseiten der Grünlinge mit den Elektroden, sodass über die Grünlinge zwischen den beiden Elektroden eine Verbindung geschaffen wird, die sowohl einen elektrischen Strom, als auch einen mechanischen Kraftfluss überträgt;

g) Beaufschlagen der Grünlinge mit einem zwischen den Elektroden fließenden elektrischen Strom, sodass innerhalb des thermoelektrischen Aktivmaterials Wärme hervorgerufen wird;

h) Beaufschlagen der Grünlinge mit einer zwischen den Elektroden wirkenden Druckkraft, sodass das thermoelektrische Aktivmaterial unter Druck gerät;

i) Sintern der Grünlinge zu Thermoschenkeln unter Einwirkung des Drucks und der Wärme;

k) Planieren des Substrats und der darin aufgenommen Thermoschenkel durch Annähern der Elektroden unter Beibehaltung ihrer Parallelität, sodass die Thermoschenkel bündig mit dem Substrat abschließen, wobei etwaiger axialer Versatz der Grünlinge in dem Substrat sowie Sinterschwund ausgeglichen wird.

Ein solches Verfahren ist Gegenstand der Erfindung

Eine Grundidee der Erfindung besteht darin, die Prozessschritte des Verpressens, des Einsetzens und des Sinterns auf unterschiedlichen Maschinen durchzuführen, um für möglichst viele Verfahrensoperationen standardisierte Maschinen verwenden zu können.

Eine wesentlicher Aspekt der Erfindung besteht darin, dass das Versintern und das Egalisieren in einem Arbeitsschritt erfolgt, indem zum Substrat planparallel angeordnete, ebene Sinterelektroden verwendet werden, welche dem Sinterschwund folgend dem Substrat angenähert werden. Die Grünlinge sind dementsprechend mit einem Übermaß zu versehen, welches mit dem Sinterschwund ausgeglichen wird. Am Ende des Sintervorgangs gibt der Abstand der Elektroden sowohl die Substratstärke als auch die Länge der Thermoschenkel vor. Dies stellt einen bündigen Abschluss der Thermoschenkel mit dem Substrat ohne weitere Nacharbeitung sicher.

Ein weiterer Rationalisierungsvorteil kann dadurch erschlossen werden, indem mehrere Substrate mit eingesetzten Grünlingen zu einem Stapel zusammengefasst werden, wobei sich die Substrate innerhalb des Stapels parallel zueinander erstrecken und jeweils zwischen zwei innerhalb des Stapels benachbarten Substraten eine im Wesentlichen ebene Trennplatte eingelegt ist, welche sich parallel zu den Substraten erstreckt und welche eine elektrisch leitfähige und Kraft übertragende Verbindung zwischen den Grünlingen der benachbarten Substrate herstellt, und dass der gesamte Stapel zwischen den beiden Elektroden angeordnet wird. Mit Hilfe der Trennplatte können in einem Sintervorgang auf einer Sintermaschine eine Vielzahl von Halbzeugen (also Substrate mit eingesetzten Thermoschenkeln) produziert werden.

Bei dem eben beschriebenen Sammelverfahren können mehrere Substrate mit eingesetzten Grünlingen einzeln bzw. gestapelt in einer Ebene zwischen den beiden Elektroden angeordnet werden. Dadurch wird die Fertigung weiter rationalisiert.

Die ebenen Elektroden bzw. die Trennplatten bestehen vorzugsweise aus Graphit, da dieser Stoff gut den elektrischen Strom leitet, die hohen Sintertemperaturen erträgt und nicht an dem thermoelektrischen Aktivmaterial anhaftet. Graphit hat die Eigenschaft, dass seine mechanische Festigkeit mit der Temperatur ansteigt. Um diesen Effekt zu nutzten sieht eine Weiterbildung der Verfahrensführung vor, dass die Grünlinge zum Kontaktieren mit einer ersten Druckkraft beaufschlagt werden, dass dann die Grünlinge unter Einwirkung der ersten Druckkraft mit Strom beaufschlagt werden, bis die aus Graphit bestehenden Elektroden bzw. Trennplatten eine Temperatur erreicht haben, bei welcher die aus Graphit bestehenden Elektroden bzw. Trennplatten eine erhöhte Tragfähigkeit bzw. Bruchlast aufweisen, welche oberhalb der ersten Druckkraft liegt, und dass die Grünlinge sodann mit der zweiten Druckkraft beaufschlagt werden, welche oberhalb der ersten Druckkraft und unterhalb der erhöhten Tragfähigkeit bzw. Bruchlast liegt. Die zum Verpressen erforderlich zweite Druckkraft wird also erst eingestellt, wenn die Elektroden bzw. die Trennplatten temperaturbedingt eine ausreichende Festigkeit erreicht haben. Bis zum Erreichen dieser Temperatur wird lediglich mit der ersten, niedrigeren Druckkraft beaufschlagt.

Das vorliegende Verfahren ist bestimmt für Verarbeitung von thermoelektrischen Aktivmaterial, bei welchem es sich um eine Legierung handelt, welche ausgewählt ist aus der Klasse der Wismuttelluride, Bleitelluride, Zinkantimonide, Silizide, Skutterudite, Halb-Häusler-Materialien. Nanoscaliges Silicum kann ebenfalls als Aktivmaterial eingesetzt werden. Besonders bevorzugt ist Wismuttellurid ($Bi_2Te_3$).

Beim Verpressen des pulverförmigen Aktivmaterials zu den Grünlingen wird das pulverförmigen Aktivmaterial verdichtet. Vorzugsweise wird das Pulver aber nicht bis zu der (theoretischen) Reindichte verdichtet, sondern lediglich bis zu einer ersten Pressdichte, welche zwischen 75 % und 85 % der Reindichte des Aktivmaterials entspricht. Die Reindichte versteht sich als die Dichte es ideal massiven Körpers aus dem eingesetzten Aktivmaterial. Die Reindichte von technischen Wismuttellurid-Legierungen beträgt beispielsweise 6.9 g/cm$^3$. Da die erste Pressdichte geringer ist als die Reindichte, ist der Grünling porös. Die erste Pressdichte ist wiederum denknotwendig größer als Schüttdichte des pulverförmigen Aktivmaterials, da das Pulver beim Pressen verdichtet wird. Die Schüttdichte des eingesetzten Pulvers liegt vorzugsweise zwischen 30 % und 50 % der Reindichte.

Um die erste Pressdichte zu erreichen, sind die Partikelgrößenverteilung des pulverförmigen Aktivmaterials und der Pressdruck in der Tablettenpresse entsprechend zu wählen. Konkret für den Fall, dass Wismuttellurid als Aktivmaterial verwendet wird, sollte dieses vor dem Verpressen eine mittlere Partikelgröße dso zwischen 3 $\mu$m und 30 $\mu$m aufweisen; der Druck, bei dem das thermoelektrische Aktivmaterial zu den Grünlingen verpresst wird, sollte dann zwischen 541 MPa und 955 MPa betragen. Die Partikelgrößenverteilung wird durch statische Laserlichtstreuung gemäß Mie-Theorie bestimmt. Dieses Analyseverfahren ist in DIN-ISO 13320 angeben; die Nassmessung ist anzuwenden. Ein geeignetes Messgerät ist das Laser-Streulichtspektrometer HORIBA LA 950 von Retsch Technology GmbH, Haan (Germany). Der Druck, der beim Verpressen des Pulvers von der Tablettenpresse aufgewendet wird, kann an der Tablettenpresse abgelesen werden. Dazu wird die Kraft an dem Stempel zum Beispiel mit einer Kraftmessdose (Dehnungsmessstreifen) bestimmt und zu der Stempelfläche in das Verhältnis gesetzt.

Die Länge der Grünlinge sollte zwischen 105 % und 150 % der Stärke des Substrats im planierten Zustand entsprechen. Dies bedeutet, dass die in das Substrat eingesetzten Grünlinge aus dem Substrat hervorstehen, was einen guten mechanischen und elektrischen Kontakt mit den Elektroden bzw. den Trennplatten ermöglicht. Der Sinterschwund lässt dann die Thermoschenkel auf Substratstärke schrumpfen, sodass eine nachträgliche Egalisierung nicht erforderlich ist.

Die beim Sintern in den Grünlingen eingestellte Temperatur sollte zwischen 50 % bis 70 % der Schmelztemperatur des Aktivmaterials entsprechen. Die Schmelztemperatur hängt von dem eingesetzten Aktivmaterial ab. Bei Wismuttellurid liegt die Schmelztemperatur bei 573°C. Sofern eine Legierung aus der Klasse der Wismuttelluride eingesetzt wird, liegt die optimale Sintertemperatur folglich zwischen 287°C und 401°C, abhängig von der konkreten Legierung.

In den Grünlingen selbst kann die Temperatur kaum gemessen werden. Hilfsweise wird beim Sintern die Temperatur mit einem Thermometer an den Elektroden gemessen. Gesteuert wird die Sintertemperatur durch den elektrischen Strom, mit welchem die Grünlinge beaufschlagt werden.

Sofern Wismuttelluride als Aktivmaterial verwendet werden, sollten die Grünlinge beim Sintern mit elektrischem Strom in der folgenden Größenordnung beaufschlagt werden:

| | |
|---|---|
| Stromdichte bezogen auf die Querschnittsfläche der Grünlinge: | 10 kA/m$^2$ bis 100 kA/m$^2$ |
| Dauer der Beaufschlagung: | 600 s bis 1100 s |
| Eintrag elektrische Energie / Einwaage Aktivmaterial: | 150 kJ/g bis 250 kJ/g |

Der Strom kann als Wechselstrom mit einer Frequenz im Bereich von 20 Hz bis 100 Hz angelegt werden. Wechselstrom mit normaler Netzfrequenz von 50 Hz oder 60 Hz ist geeignet. Es ist auch möglich, Gleichstrom zu verwenden.

Durch die Beaufschlagung mit elektrischem Strom erhitzen sich die Elektroden und die Grünlinge auf Temperaturen zwischen 300°C bis 400°C. Die Temperatur kann in den Elektroden gemessen und als Regelgröße genutzt werden. Die hohe Temperatur bewirkt die Versinterung des Aktivmaterials. Der gesinterte Grünling entspricht dem Thermoschenkel. Da durch das Versintern der elektrische Widerstand des Aktivmaterials sinkt, steigt die thermoelektrische Aktivität der versinterten Schenkel gegenüber den porösen Grünlingen.

Für jedes Thermopaar sind je zwei unterschiedlich leitende thermoelektrische Aktivmaterialien notwendig, die elektrisch miteinander verbunden werden, wobei das erste Aktivmaterial z. B. p-leitend und das zweite Aktivmaterial n-leitend ist, oder umgekehrt. Unterschiedlich bedeutet hier, dass die beiden Aktivmaterien einen unterschiedlichen Seebeck-Koeffizienten aufweisen. P- und n-leitende Halbleiter sind als Aktivmaterialien besonders bevorzugt, da ihre Seebeck-Koeffizienten unterschiedliche Vorzeichen (negativ bei n-Leitern, positiv bei p-Leitern) aufweisen und daher der numerische Unterschied der Seebeck-Koeffizienten besonders groß ist. Dies erhöht die Effizienz des thermoelektrischen Bauelements.

In einer ersten Variante dies Herstellungsverfahrens werden beide Aktivmaterialien nacheinander zu den jeweiligen Grünlingen verpresst und eingesetzt. Das bedeutet, es werden erst Grünlinge aus p-leitenden Material erzeugt und in das Substrat eingesetzt und sodann das n-leitende Aktivmaterial verarbeitet. Dadurch werden die Umrüstzeiten der Maschine reduziert. Selbstverständlich kann auch erst das n-leitende Material verarbeitet werden gefolgt von dem p-leitenden Material.

Eine zweite und bevorzugte Variante sieht es indes vor, dass zwei Tablettenpressen verwendet werden, eine erste für das p-leitende Aktivmaterial und eine zweite für das n-leitende Aktivmaterial. Die gegenüber der ersten Variante verdoppelten Investitionskosten amortisieren sich rasch durch Reduktion der Umrüstzeiten: Da innerhalb eines Thermoschenkels n- und p-leitende Materialien nicht vermischt werden dürfen, ist es zwingend erforderlich, die Maschine beim Materialwechsel gründlich zu reinigen. Insbesondere bei der Verwendung von komplexen Rundläuferpressen fallen die Rüstzeiten dadurch sehr lang aus. Bei der Verwendung von zwei Maschinen, die jeweils sortenrein betrieben werden, entfallen die Rüstzeiten und die Maschinennutzungsdauer verlängert sich deutlich. Darüber hinaus bewirkt die Verwendung dedizierter Pressen für n-leitendes und p-leitendes Aktivmaterial eine Qualitätsverbesserung, da Kontamination der Schenkel durch Fremdmaterial weitgehend ausgeschlossen wird.

Die Druckkraft, die auf den Grünlingen beim Versintern lastet, ist deutlich niedriger als der Druck zuvor beim Verpressen des Pulvers zu den Grünlingen.

Vorzugsweise werden die Grünlinge beim Beaufschlagen mit der zwischen den Elektroden wirkenden Druckkraft auf eine zweite Pressdichte verdichtet, welche zwischen 90 % und 97 % der Reindichte des Aktivmaterials entspricht. Die Dichte der Grünlinge unmittelbar vor dem Sintern wird folglich nochmal erhöht, die theoretische Reindichte (Definition wie oben) jedoch nicht eingestellt.

Im Falle von Wismuttellurid sollte der Grünling mit einer Druckkraft beaufschlagt werden, welche zu einem Druck zwischen 10 MPa bis 50 MPa in dem thermoelektrischen Aktivmaterial führt.

Kaltes Graphit hat normalerweise eine Druckfestigkeit von 60 MPa bis 120 MPa. Deswegen sollten Graphitelektroden / Trennplatten erst auf einen Temperatur von etwa 300°C aufgeheizt werden, bevor die endgültige Druckkraft angelegt wird. Bei dieser Temperatur haben die Graphitelemente die notwendige Bruchfestigkeit erreicht, um den Sinterdruck schadlos zu ertragen. Die Heizrate zum Einstellen der Temperatur sollte etwa 50 K/min betragen.

Die in diesem Verfahren eingesetzten Grünlinge können unterschiedliche geometrische Gestalten aufweisen. Zunächst kommt eine allgemeine Zylinderform in Betracht. Diese muss nicht zwangsläufig auf einer kreisförmigen Grundfläche basieren, sie kann auch elliptisch, rechteckig, quadratisch oder hexagonal sein. Es sind auch zylindrische Grünlinge einsetzbar, die auf einem regelmäßigen oder unregelmäßigen n-Eck basieren. Besonders bevorzugt weisen die Grünlinge jedoch eine kreiszylindrische Gestalt auf.

Neben einer Zylinderform können die Grünlinge auch leicht kegelförmig sein. Dies bedeutet, dass die Grundfläche in axialer Richtung abnimmt, der Grünling sich verjüngt. Der Vorteil eines sich verjüngenden Grünlings besteht darin, dass er in dem Durchgangsloch des Substrats klemmend festsitzt und bei Handhabung des Substrats mit eingesetztem Grünling nicht herausfällt. Der Kegelwinkel ist dementsprechend so zu wählen, dass eine ausreichende Klemmkraft zwischen Substrat und eingesetztem Grünling entsteht. Gleichwohl darf der Kegelwinkel nicht zu steil sein, um das Substrat nicht unter Keilwirkung zu spalten. Ein geeigneter Kegelwinkel hängt auch von dem Reibungskoeffizient und damit von der Materialpaarung ab.

Dieselbe Wirkung kann auch erzielt werden durch ein sich verjüngendes Durchgangsloch oder dadurch, dass die Grünlinge mit einem radialen Übermaß in die Durchgangslöcher eingesetzt werden (Presspassung).

Um kreiszylindrische Grünlinge gut in das Substrat einsetzen zu können, sollten diese stirnseitig jeweils eine Fase aufweisen. Dies gilt umso mehr, wenn die Grünlinge ein radiales Übermaß aufweisen. Dank der Fase platzt beim Einsetzten der Grünlinge auch kein Material ab (Scharfe Kanten brechen leicht ab). Die Grünlinge sind auch unempfindlicher gegenüber Beschädigung durch Stöße. Schließlich ist auch die Gefahr der Ausbildung eines "Pilzkopfes" (bzw. einer "Nietenbildung") des Überstands beim Versintern herabgesetzt.

Die Grünlinge können auch mit einer glatten Oberfläche versehen werden, damit sie gut in die Löcher des Substrats hineingleiten. Die Oberflächenqualität der Grünlinge ist durch die Form, die Dosiergüte und dem Druck beim Verpressen vorgegeben. Vorzugsweise weist die Mantelfläche der Grünlinge einen gemäß DIN 4766 T2 bestimmten

Mittenrauwert $R_a$ zwischen 12 μm und 24 μm auf.

Ein wesentlicher Vorteil des hier beschriebenen Verfahrens besteht darin, dass die Grünlinge auf einer standardisierten Maschine außerhalb des Substrats verpresst werden können. Hierfür eignen sich überraschenderweise von der Stange erhältliche Tablettenpressen, wie sie in der pharmazeutischen Industrie eingesetzt werden, um pulverförmige Arzneimittel zu tablettieren. Dieser Befund ist deshalb überraschend, da Tablettenpressen für die Verarbeitung von pharmazeutischen Formulierungen bestimmt sind, die sich chemisch und physikalisch signifikant von thermoelektrischem Aktivmaterial unterscheiden. So etwa weist Wismuttellurid eine mit üblichen Arzneistoffen verglichen äußerst große Dichte auf.

Gleichwohl erreichen Tablettenpressen in Exzenter- oder Rundläufer-Bauweise ohne Modifikation die für die Verpressung von thermoelektrischen Aktivmaterial zu Grünlingen erforderlichen Pressdrücke und können aus dem Aktivmaterial mit hoher Geschwindigkeit große Mengen Grünlinge vollautomatisch herstellen. Anstatt mit Arzneimitteln wird die Tablettenpresse mit pulverförmigen thermoelektrischem Aktivmaterial beschickt. Die Stempelpresskräfte sind so einzustellen, dass die erforderlichen Pressdrücke (700 MPa bis 1200 MPa bei $Bi_2Te_3$) in der Form erreicht werden. Es sind entsprechend hochbelastbare Stempel zu wählen. Im Ergebnis kann die aufwändige Neuentwicklung einer Sondermaschine durch die Anschaffung einer unmittelbar verfügbaren Tablettenpresse umgangen werden.

Eine geeignete Tablettenpresse in Rundläuferbauweise ist Typ 1200i von Fette Compacting GmbH, Schwarzenbek (Germany). Wie oben ausgeführt, werden vorzugsweise zwei Tablettenpressen angeschafft, um n- und p-dotierte Grünlinge getrennt zu produzieren.

Ein weiterer Vorteil von pharmazeutischen Tablettenpressen ist, dass diese von Hause aus mit exakt arbeitenden Dosiereinrichtungen ausgerüstet sind; die Einwaage des Aktivmaterials in die Form erfolgt damit "out-of-the-box" hochgenau. Die Dosierung erfolgt über eine Volumenmessung.

Ein weiterer Vorteil des Einsatzes von vereinzelten, ex situ auf der Tablettenpresse hergestellten Grünlingen ist, dass fehlerhafte Grünlinge leichter ausgesondert und deren Aktivmaterial durch Aufmahlen rezykliert werden können. Werden die Grünlinge in situ (also im Substrat) verpresst oder massenhaft direkt aus der Form in das Substrat überführt, können einzelne, fehlverpresste Grünlinge in das Substrat gelangen und die Qualität des späteren TEG mindern.

Eine Tablettenpresse stößt die Grünlinge ungeordnet aus. Zum einzelnen Einsetzen der Grünlinge in das Substrat kann eine kommerziell erhältliche Vereinzelungs- und Fördereinrichtung eingesetzt werden, wie sie normalerweise zum Einsetzen von Tabletten in Blisterverpackungen genutzt werden. Vorzugsweise werden Fördermaschinen mit Piezo-Aktuatoren verwendet oder Schwingförderer. Geeignete Maschinen sind bei der Firma Harro Höflinger Verpackungsmaschinen GmbH, Allmersbach im Tal, Germany erhältlich. Es können auch andere Bestückungsautomaten verwendet werden oder die Grünlinge werden von Hand in das Substrat eingesetzt.

Grundsätzlich eröffnet das erfindungsgemäße Verfahren die Möglichkeit, aus einer breiten Palette von möglichen Substratmaterialien zu wählen. Zur Steigerung der Effizienz des thermoelektrischen Generators sollte möglichst ein Substratmaterial gewählt werden, was in einem hohen Maße thermisch und elektrisch isoliert. Allerdings muss das Substratmaterial auch preisgünstig verfügbar sein, um die Wirtschaftlichkeit sicherzustellen. Weiterhin muss das Substratmaterial eine für den weiteren Fertigungsweg und die spätere Nutzung im thermoelektrischen Bauelement geeignete Temperatur(wechsel-)beständigkeit aufweisen. Eine gewisse mechanische Festigkeit muss ebenfalls gegeben sein.

Als besonders wirtschaftliches Substratmaterial bieten sich Verbundwerkstoffe an, die aus anorganischen Rohstoffen und Bindemitteln aufgebaut sind. Bei den anorganischen Rohstoffen handelt es sich vorzugsweise um Glimmer, Perlite, Phlogopite, oder um Muscovite. Als Bindemittel wird vorzugsweise Silikon, Silikonharz und/oder Epoxidharz verwendet. Mit diesen Materialien lassen sich insbesondere als Schichtwerkstoff aufgebaute Substrate laminieren. Als Substrat bestens geeignet sind die unter dem Markennamen Miglasil® und Pamitherm® erhältlichen Isolationsplatten der Schweizer Firma von Roll AG. Es handelt sich dabei um Laminate, die aus Silikon-gebundenen Muscoviten aufgebaut sind. Dieses temperaturstabile Isolationsmaterial lässt sich hervorragend im erfindungsgemäßen Prozess verarbeiten.

Bei der Verwendung von laminierten Substratmaterialien aus anorganischen Rohstoffen und Bindern ist die Einhaltung von geeigneten Maschinenparametern während der mechanischen Bearbeitung wichtig, um Beschädigungen des Materials zu vermeiden. So sollte beim spanenden Lochen von Pamitherm-Platten mit Vollhartmetallbohrern eine Schnittgeschwindigkeit im Bereich von 0.3 m/s bis 1.5 m/s eingehalten werden. Bei einem Bohrerdurchmesser von 4 mm bedeutet dies Drehzahlen von ca. 1500 /min bis 7500 /min. Der Vorschub sollte im Bereich von 50 mm/min bis 250 mm/min liegen. Es können ebenso auch spezielle für Laminate entwickelte Bohrer und Fräsbohrer verwendet werden.

Als Alternative zum Bohren besteht auch die Möglichkeit, das Substrat spanlos zu lochen, etwa mit einem Schneidstempel.

Das Substrat wird als ebenes Material verwendet mit einer Stärke zwischen 1 mm und 10 mm. Bevorzugt liegt die Stärke zwischen 1.5 mm und 4 mm, ganz besonders bevorzugt zwischen 2 mm und 3 mm. Pamitherm®-Platten werden in dieser Schichtstärke angeboten.

Das Verfahren soll nun anhand von schematischen Zeichnungen näher erläutert werden. Hierfür zeigen:

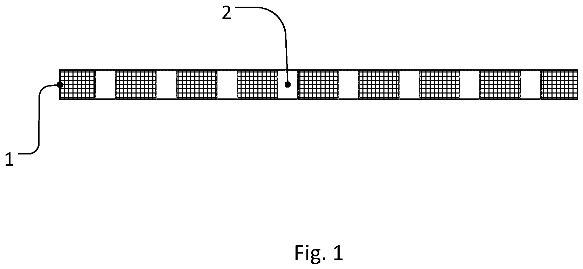

Figur 1:          Bereitstellen eines Substrats;

Figur 2a bis 2f: Bereitstellen von Aktivmaterial und Verpressen des Aktivmaterials zu Grünlingen;

Figur 3: Einsetzen der Grünlinge in das Substrat;

Figur 4: Anordnen des Substrats zwischen zwei Elektroden;

Figur 5: Kontaktieren der Stirnseiten der Grünlinge mit den Elektroden;

Figur 6: Beaufschlagen der Grünlinge mit Strom und Druckkraft zwecks Sintern der Grünlinge zu Thermoschenkeln;

Figur 7: Planieren des Substrats und der Thermoschenkel durch Annähern der Elektroden;

Figur 8: Halbzeug;

Figur 9: thermoelektrisches Bauelement;

Figur 10: Variante: Stapelweise Anordnung mehrerer Substrate zwischen zwei Elektroden mit Hilfe von Trennplatten;

Figur 11; Sintern des Stapels.

Zunächst wird ein Substrat 1 bereitgestellt. Bei dem Substrat 1 handelt es sich um eine im ebene Platte aus Pamitherm®. Dabei handelt es sich um ein thermisch und elektrisch isolierendes Laminat welches aus Silikon-gebundenen Muscoviten aufgebaut ist. Die Flächengröße und -form hängt von Einsatzzweck des späteren TEG ab. Beispielsweise können rechteckige Platten der Größe 52 mm x 52 mm verwendet werden. Die Materialstärke der Pamitherm®-Platte beträgt 2 mm. Die Größenverhältnisse in den Zeichnungen sind nicht maßstäblich.

Das Substrat 1 wird mit einer Vielzahl von Durchgangslöchern 2 versehen, welche sich senkrecht zur Ebene des Substrats 1 durch das Substrat hindurch erstrecken. Da Pamitherm®-Platten ungelocht ausgeliefert werden, sind die Durchgangslöcher 2 hineinzubohren. Dies erfolgt mit einem Hartmetallbohrer. Die Durchgangslöcher haben entsprechend einen kreisförmigen Querschnitt mit 4.07 mm Durchmesser. Gleichwohl können auch andere Querschnittsformen für die Durchgangslöcher vorgesehen sein, wie etwa hexagonal, um die Packungsdichte zu steigern. Die mittlere Packungsdichte bei Kreislöchern mit 4.07 mm Durchmesser beträgt zwischen zwei und drei Durchgangslöcher pro Quadratzentimeter Substratfläche bei einer Stegbreite von 2mm. In den Figuren sind vereinfachend acht Durchgangslöcher 2 dargestellt.

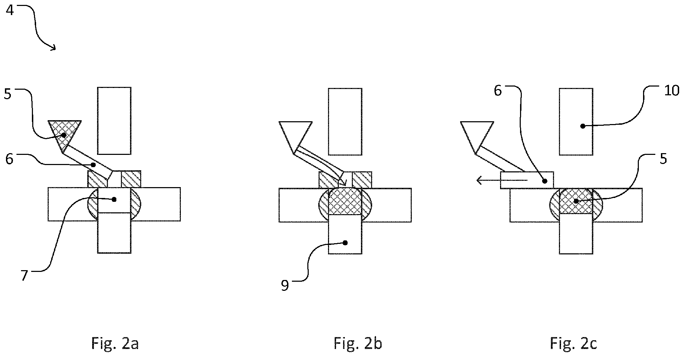

Die Figuren 2a bis 2f zeigen schrittweise den zyklischen Ablauf der Herstellung eines Grünlings 3 auf einer Tablettenpresse 4. Die Tablettenpresse ist vereinfacht in Exzenter-Bauweise dargestellt.

Zum Herstellen der Grünlinge 3 wird zunächst wird ein pulverförmiges thermoelektrisches Aktivmaterial 5 bereitgestellt. Dabei handelt es sich um Wismuttellurid-Pulver mit einer Partikelgröße dso von etwa 8 $\mu$m. Das Pulver wird in einen Einfülltrichter 6 der Tablettenpresse 4 bereitgestellt; vgl. Fig. 2a.

Die Tablettenpresse 4 dosiert eine voreingestellte Menge von etwa 200 mg des Wismuttellurid-Pulvers 5 in eine Form 7; vgl. Fig. 2b.

Die Form 7 ist Teil der Tablettenpresse 4 und wird von den Herstellern von Tablettenpressen meist als "Matrize" bezeichnet. Dieser Begriff wird hier bewusst nicht gebraucht, da einige Hersteller von thermoelektrischen Generatoren den hier als Substrat bezeichneten Teil eines TEG als Matrix oder Matrize bezeichnen. In der hier verwendeten Terminologie bezeichnet der Begriff "Form" stets einen den Teil der Tablettenpresse und "Substrat" stets einen Teil des TEG.

Die Form 7 ist nach unten von einem Unterstempel 9 verschlossen ist. Die Form 7 ist kreiszylindrisch mit einem Durchmesser etwa entsprechend dem Durchmesser der Durchgangslöcher 2. Die Länge der Grünlinge variiert zwischen 2.2 mm und 2.6 mm. Das entspricht also zwischen 110 % bis 135 % der Substratstärke. Die Grünlinge weisen also gegenüber dem Substrat ein axiales Übermaß auf. Ggf. kann der Durchmesser der Form 7 geringfügig größer sein als der der Durchgangslöcher 2, um Grünlinge mit einem radialen Übermaß zu produzieren.

Nach Befüllung der Form mit Aktivmaterial wird der Einfülltrichter 6 beiseite gezogen; vgl. Figur 2c.

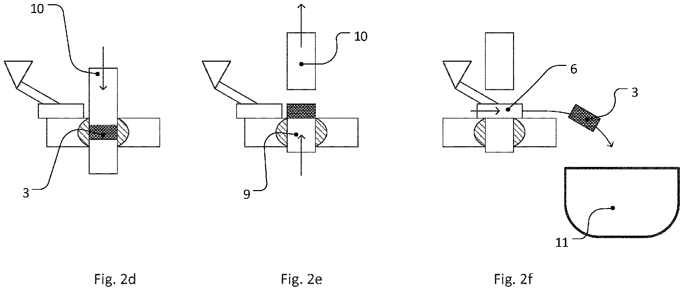

Ein linear geführter Oberstempel 10 verdichtet das Pulver 5 innerhalb der Form 7 zu einem kreiszylindrischen Grünling 3 (Figur 2d). Die Stempelkraft liegt bei etwa 8.5 kN. Daraus resultiert innerhalb der Form ein Druck von 676 MPa.

Sodann fährt der Oberstempel 10 zurück. Der Unterstempel 9 folgt ihm und drückt dabei den Grünling 3 aus der Form 7 heraus (Figur 2e).

Schließlich fährt der Einfülltrichter 6 in seine vorherige Position über der Form zurück und wirft dabei den Grünling 3 aus der Tablettenpresse 4 aus. Der ausgestoßene Grünling 3 wird in einem Sammelgefäß 11 ungeordnet gesammelt (Fig. 2f). Der Unterstempel 9 wird wieder herab gefahren, sodass die Maschine wieder in die in Figur 2a dargestellten Ausgangsstellung gelangt. Der Einfülltrichter 6 wird erneut Aktivmaterial 5 befüllt.

Auf der Tablettenpresse 4 werden die Schritte 2a bis 2f in hoher Geschwindigkeit wiederholt, sodass eine Vielzahl von Grünlingen nacheinander produziert werden kann. Da jeweils dieselbe Form 7 verwendet wird und das Pulver genau dosiert werden kann, sind die Grünlinge von gleichbleibender Qualität hinsichtlich Maßhaltigkeit, Dichte und Oberflächenqualität. Etwaige Fehlpressungen werden aussortiert.

Um die Produktionsgeschwindigkeit zu steigern, kann anstelle der schematisch dargestellten Exzenterpresse eine Rundläuferpresse verwendet werden. Eine Rundläuferpresse weist eine Vielzahl von Oberstempeln, Unterstempeln und Formen auf, die kreisförmig auf einem rotierenden Läufer angeordnet sind. Die Ober- und Unterstempel werden entlang einer feststehenden Kulisse geführt, um die axiale Hubbewegung der Stempel relativ zur Form zu erzeugen. Die Presskräfte werden von Druckrollen auf die Stempel aufgebracht. Derartige Rundläuferpressen werden in der industriellen Produktion von pharmazeutischen Tabletten verwendet und sind auf große Durchsatzgeschwindigkeit optimiert.

Da die beiden Schenkel eines Thermopaares möglichst unterschiedliche Seebeck-Koeffizienten aufweisen müssen, um eine hohe Thermospannung zu erzeugen, werden zwei unterschiedliche Sorten von thermoelektrischen Aktivmaterials verpresst, nämlich einmal n-dotiertes Wismuttellurid und einmal p-dotiertes. Somit werden nacheinander zwei unterschiedliche Sorten von Grünlingen auf derselben Presse produziert, einmal die aus n-dotierten Aktivmaterial und einmal aus p-dotierten Aktivmaterial. Damit sich Reste des n-dotiertem Aktivmaterials nicht in den p-dotierten Grünlingen wiederfinden, muss die Maschine zwischendurch gründlich gesäubert werden. Um dies zu vermeiden, können die p- und n-dotierten Aktivmaterialien auch auf getrennten Maschinen verarbeitet werden.

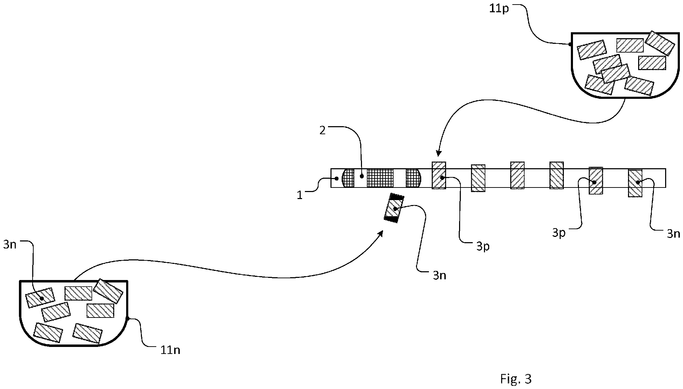

Figur 3 zeigt zwei Sammelgefäße 11p und 11n die jeweils gefüllt sind mit einer Vielzahl von p-dotierten Grünlingen 3p bzw. n-dotierten Grünlingen 3n. Die Grünlinge 3n, 3p befinden sich sortenrein, aber geometrisch ungeordnet in den jeweiligen Sammelgefäße 11n, 11p.

Die Grünlinge 3n, 3p werden aus den jeweiligen Sammelgefäßen 11p, 11n entnommen und einzeln in die Durchgangslöcher 2 des Substrats 1 eingesetzt, sodass sich die Grünlinge axial durch die Durchgangslöcher und damit senkrecht zur Substratebene erstrecken. Hierfür wird ein pharmazeutischer Bestückungsautomat verwendet (nicht dargestellt). Alternativ können die Grünlinge 3n. 3p von Hand in das Substrat 1 eingesetzt werden.

Es werden alternierend p- und n-dotierte Grünlinge 3p, 3n nebeneinander angeordnet. Jeweils ein benachbarter p- und n-dotierter Grünling bilden später ein Thermopaar. Es ist unerheblich, ob erst alle Grünlinge einer Sorte eingesetzt werden und danach die andere Sorte oder jeweils abwechselnd oder reihenweise oder in einem anderen beliebigen Muster.

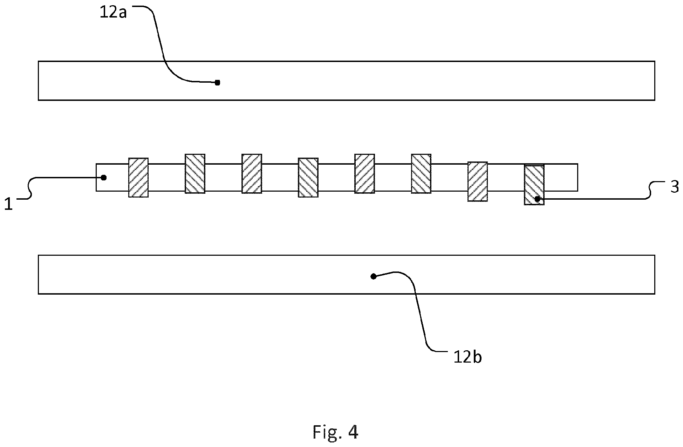

Sodann wird das Substrat 1 mit den eingesetzten Grünlingen 3 zwischen zwei im Wesentlichen ebenen Elektroden 12a, 12b angeordnet; vgl. Figur 4. Es ist wichtig, dass das Substrat 1, die erste Elektrode 12a und die zweite Elektrode 12b jeweils parallel zueinander ausgerichtet sind.

Unwichtig ist hingegen, ob die Stirnseiten der eingesetzten Grünlinge 3 in einer gemeinsamen Ebene liegen. Wie aus Figur 4 erkennbar ist, sind die Grünlinge mit uneinheitlichen axialen Versatz in das Substrat 1 eingebracht, weswegen ihre Stirnseiten nicht in einer Ebene liegen. Grund dafür ist, dass der Bestückungsautomat nicht so genau arbeitet, dafür aber schnell.

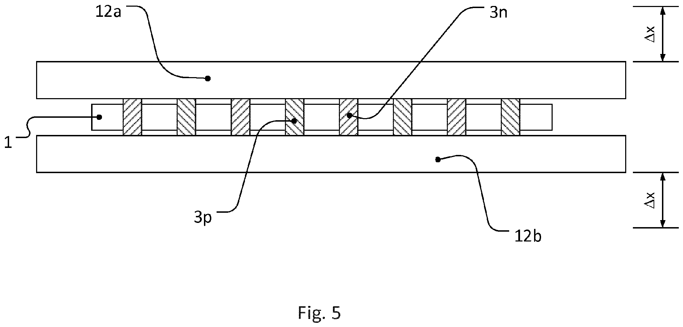

Gemäß der Erfindung werden die Stirnseiten der Grünlinge mit Hilfe der Elektroden in eine Ebene gebracht. Dafür werden die beiden Elektroden 12a, 12b jeweils um den Weg $\Delta x$ aufeinander zu bewegt unter Beibehaltung ihrer Parallelität. Dabei kontaktieren die ebenen Elektroden die Stirnseiten der Grünlinge und richten diese in der Ebene der jeweils die Stirnseite kontaktierende Elektrode 12a, 12b aus. In Figur 5 ist zu erkennen, dass die Grünlinge 3n, 3p nunmehr allesamt in einer Ebene liegen.

Da die Stirnseiten aller Grünlinge 3n, 3p unmittelbar an den Elektroden 12a, 12b anliegen, kann über die Grünlinge zwischen den Elektroden sowohl ein elektrischer Stromkreis, als auch ein mechanischer Kraftfluss geschlossen werden.

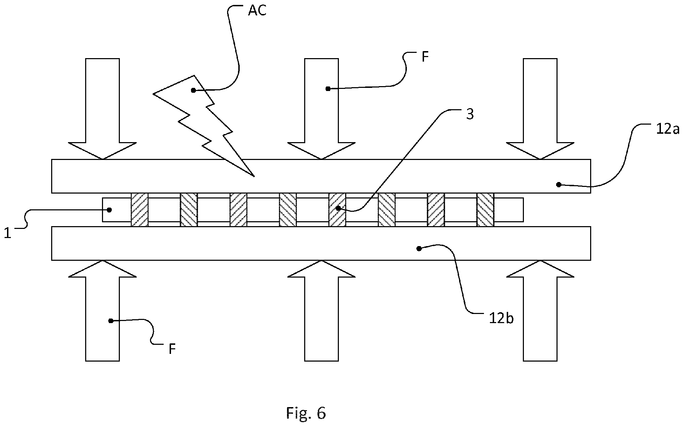

Dies geschieht in Figur 6. Beide Elektroden werden jeweils mit einer axial zu den Grünlingen ausgerichteten, in Richtung des Substrats 1 wirkenden Kraft F beaufschlagt. Diese ist unter Berücksichtigung der kontaktierten Stirnflächen der Grünlinge so bemessen, dass auf das Aktivmaterial eine mechanische Druckspannung von 30 MPa wirkt. Zudem wird eine Wechselspannung AC mit 50 Hz zwischen den Elektroden angelegt, deren Spannung so bemessen ist, dass unter Berücksichtigung der kontaktierten Stirnflächen der Grünlinge ein Wechselstrom mit einer Stromdichte von 50 kA/m$^2$ durch die Grünlinge fließt.

Aufgrund des ohmschen Widerstands des Aktivmaterials heizen sich Grünlinge bis zu einer Temperatur zwischen 300 °C und 400°C auf, in dem Bereich wo auch die optimale Sintertemperatur liegt. Unter der mechanischen Druckeinwirkung versintern die einzelnen Partikel der Grünlinge, sodass aus dem verpressten Pulvermaterial ein fester Sinterkörper wird. Die versinterten Grünlinge stellen die Thermoschenkel 13 dar.

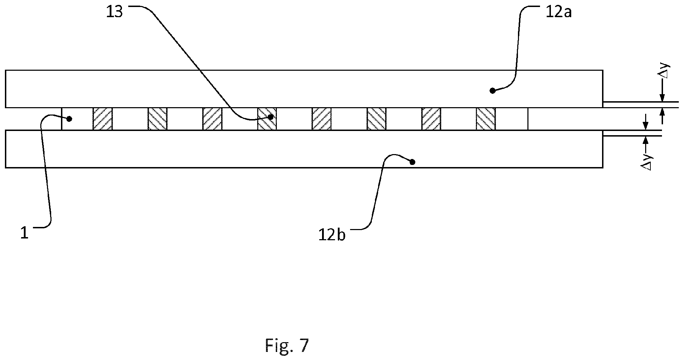

Beim Versintern verdichten sich die Grünlinge, sodass die Thermoschenkel entsprechend ein kleineres Volumen aufweisen (Sinterschwund). Um trotz des fortschreitenden Sinterschwunds den elektrischen und mechanischen Kontakt zwischen den Grünlingen 3 und den Elektroden 12 aufrecht zu erhalten, werden die beiden Elektroden 12a, 12b dem Sinterschwund folgend in Richtung des Substrats 1, jeweils um die Wegstrecke $\Delta y$ unter Beibehaltung ihrer Parallelität nachgeführt (Figur 7).

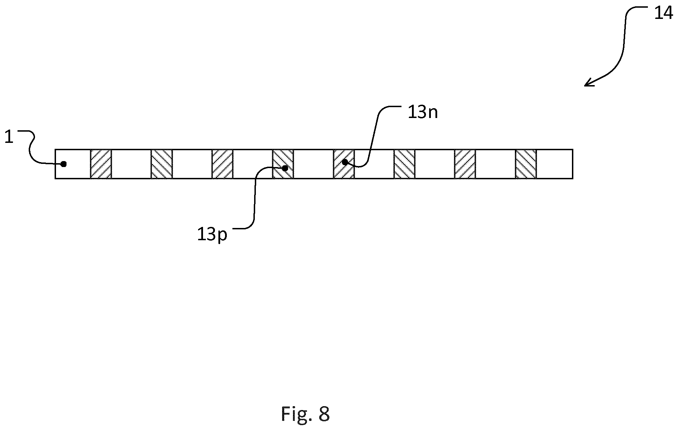

Die Länge der Grünlinge 3 ist unter Berücksichtigung des Sinterschwundes so gewählt, dass die Thermoschenkel 13n, 13p nach dem Sintern bündig mit dem Substrat 1 abschließen; vgl. Figur 8. Bei der Materialkombination Pamitherm® / Wismuttellurid sollte das Übermaß der Grünlinge etwa 15% der Substratstärke betragen, damit während des Sinterns die Grünlinge auf Substratstärke schrumpfen. Auf diese Weise erübrigt sich ein späteres separates Planieren des Werkstücks. Außerdem wird durch Begrenzung der Wegstrecke $\Delta y$ verhindert, dass das Substrat 1 zwischen den beiden Elektroden 12a, 12b eingezwängt und komprimiert wird. Etwaige Elastizität des Substratmaterials könnte andernfalls eine Rückstellung des Substrats über die Stirnflächen der Thermoschenkel hinaus bewirken, was die spätere Kontaktierbarkeit der Thermoschenkel erschwert. Vielmehr wird direkt aus dem Sinterprozess ein Halbzeug 14 des späteren thermoelektrischen Bauelements erhalten, welches beidseitig plan ist und bei dem die Stirnflächen der Thermoschenkel 13 mit der Oberfläche des Substrats auf beiden Seiten fluchten. Das Halbzeug 14 ist in Figur 8 dargestellt.

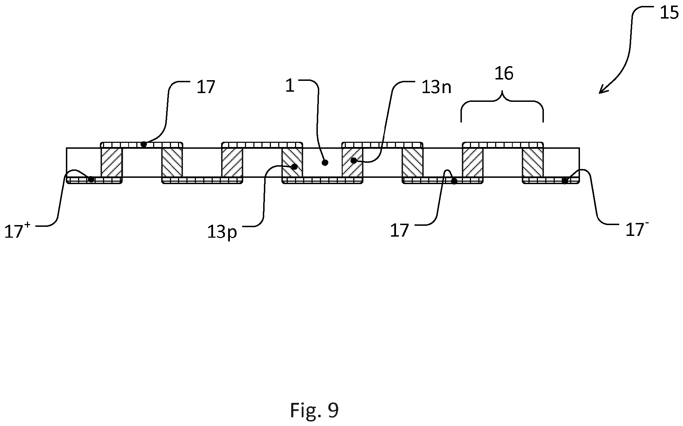

Um aus dem Halbzeug ein thermoelektrisches Bauelement 15 zu fertigen, ist es erforderlich, die Thermoschenkel paarweise zu Thermopaaren 16 zusammenzufassen. Jeweils ein Thermoschenkel 13p aus p-dotiertem Aktivmaterial und ein Thermoschenkel 13n aus n-dotiertem Aktivmaterial bilden ein Thermopaar 16. Darüber hinaus müssen die Thermopaare 16 in Serie verschaltet werden. Beides geschieht mit Hilfe von elektrisch und thermisch gut leitfähigen Kontaktbrücken 17, die auf die Stirnseiten Thermoschenkel 13n, 13p wechselseitig aufgelötet werden (Figur 9).

Das so erhaltene thermoelektrische Bauelement 15 ist so bereits funktionsfähig: Wenn das Substrat 1 zwischen einer Wärmequelle und einer Wärmesenke platziert wird, sodass über die Kontaktbrücken und durch die Thermoschenkel 13 hindurch Wärme von der einen Seite des Substrats auf die andere fließt, kann an den einseitig freien Kontaktbrücken 17+, 17- eine Thermospannung abgegriffen werden. Das thermoelektrische Bauelement 15 arbeitet dann als thermoelektrischer Generator. Umgekehrt kann durch Anlegen einer elektrischen Spannung an die einseitig freien Kontaktbrücken 17+, 17- ein Wärmefluss von der kalten Seite des Substrats auf die warme Seite induziert werden (Peltier-Element). Damit kein elektrischer Kurzschluss entsteht, wäre das gesamte thermoelektrische Bauelement 15 noch mit einer thermisch leitenden und elektrisch isolierenden Hülle zu versehen, welche es auch vor mechanischer Beschädigung schützt (nicht dargestellt).

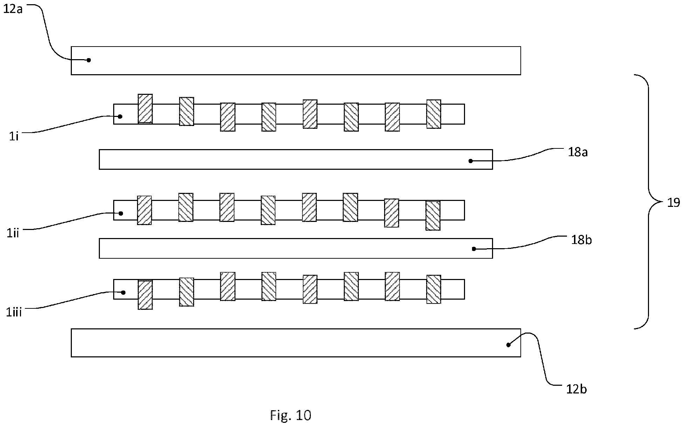

In Figur 10 ist eine besonders rationelle Verfahrensvariante gezeigt, in der mehrere Substrate 1i, 1ii und 1iii mit eingesetzten Grünlingen gleichzeitig versintert werden. Hierfür werden die drei Substrate 1i, 1ii und 1iii zwischen den beiden Elektroden 12a und 12 b angeordnet. Zwischen dem innen liegenden Substrat 1ii und den beiden außen liegenden Substraten 1i und 1iii wird jeweils eine ebene Trennplatte 18a, 18b eingelegt. Ein Stapel 19 entsteht. Die beiden ebenen Trennplatten 18a, 18b bestehen wie die Elektroden 12a, 12b aus Graphit. Alle Substrate 1i, 1ii und 1iii, beide Elektroden 12a, 12b und beide Trennplatten 18a, 18b sind planparallel zueinander ausgerichtet und bilden einen Stapel 19.

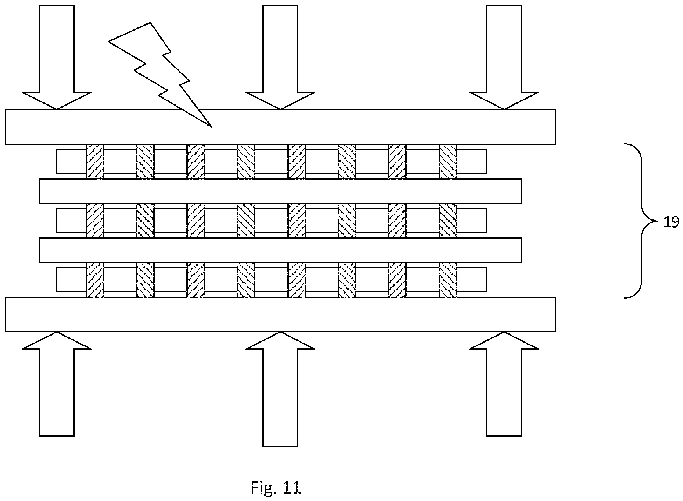

Der Stapel 19 wird in einem Arbeitsgang gesintert und dadurch drei Halbzeuge gleichzeitig hergestellt (Figur 11). Das Sintern des Stapels 19 erfolgt wie zu Figur 6 geschildert.

Es können auch mehrere Substrate mit eingesetzten Grünlingen gleichzeitig dem Sinterprozess unterworfen werden, ohne sie zu stapeln. Dafür werden die Substrate in einer Ebene nebeneinander liegend zwischen die Elektroden eingelegt. Dies spart die Trennplatten, erfordert aber Elektroden, die einen größeren Flächeninhalt aufweisen als ein einzelnes Substrat. Gezeichnet ist diese Variante der Erfindung nicht.

Eine Kombination beider Anordnungen ist ebenfalls möglich.

Unabhängig von der Anordnung und der Anzahl der Substrate zwischen den Elektroden kann der Sinterprozess im Übrigen so gesteuert werden, dass die Grünlinge zunächst mit einer Kraft $F_1$ beaufschlagt werden, die kleiner ist als eine Kraft $R_{kalt}$, welche der Bruchlast der Elektroden 12a,b bzw. der Trennplatten 18a,b im kalten Zustand (Raumtemperatur $T_0$) entspricht. Sodann wird die Wechselspannung angelegt und dadurch die Grünlinge auf eine Temperatur $T_{grenz}$ aufgeheizt, die niedriger liegt als die Sintertemperatur $T_{sinter}$, bei der sich aber die Bruchlast der Graphitelemente auf $R_{heiß}$ erhöht. Erst nach Erreichen der höheren mechanischen Festigkeit wird die Kraft auf $F_2$ erhöht, aus welcher der erforderliche mechanische Sinterdruck resultiert. Nach Erreichen des Sinterdrucks wird die Temperatur auf die benötigte Sintertemperatur $T_{sinter}$ erhöht und der Sintervorgang unter diesen Bedingungen durchgeführt. Es gelten also diese beiden Zusammenhänge:

$$F_1 < R_{kalt} < F_2 < R_{heiß} \qquad (1)$$

$$T_0 < T_{grenz} < T_{sinter} \qquad (2)$$

Diese Vorgehensweise lässt beim Sintern von einzelnen Substraten (Fig. 6), mehreren Substraten nebeneinander ohne Trennplatten oder auch von Stapeln mit Trennplatten (Fig. 11) anwenden. Maßgeblich ist immer die geringste Bruchlast der eingesetzten Graphitelemente.

**Bezugszeichenliste**

1      Substrat

1i      erstes Substrat (außen liegend)
1ii      zweites Substrat (innen liegend)
1iii      drittes Substrat (außen liegend)
2      Durchgangslöcher
3      Grünling
3n      n-dotierter Grünling
3p      p-dotierter Grünling
4      Tablettenpresse
5      thermoelektrisches Aktivmaterial in Pulverform ($Bi_2Te_3$)
6      Einfülltrichter
7      Form
8      nicht vergeben
9      Unterstempel
10      Oberstempel
11      Sammelgefäß (allgemein)
11n      Sammelgefäß für n-dotierte Grünlinge
11p      Sammelgefäß für p-dotierte Grünlinge
12a      erste Elektrode
12b      zweite Elektrode
$\Delta x$      Weg der Elektroden beim Kontaktieren
$\Delta y$      Weg der Elektroden beim Sintern
F      Kraft
AC      Wechselspannung
13      Thermoschenkel
13n      Thermoschenkel aus n-dotiertem Aktivmaterial
13p      Thermoschenkel aus p-dotiertem Aktivmaterial
14      Halbzeug
15      thermoelektrisches Bauelement
16      Thermopaar
17      Kontaktbrücke
17[+]      einseitig freie Kontaktbrücke
17[-]      einseitig freie Kontaktbrücke
18a      erste Trennplatte
18b      zweite Trennplatte
19      Stapel

## Patentansprüche

1. Verfahren zur Herstellung eines thermoelektrischen Bauelements oder zumindest eines Halbzeugs desselben, **gekennzeichnet durch** die folgenden Schritte:

a) Bereitstellen eines im Wesentlichen ebenen Substrats (1) aus einem elektrisch und thermisch isolierenden Substratmaterial, durch welches sich im Wesentlichen senkrecht zur Substratebene ausgerichtete Durchgangslöcher (2) erstrecken;
b) Bereitstellen von pulverförmigem, thermoelektrisch aktivem Aktivmaterial (5);
c) Verpressen des Aktivmaterials zu Grünlingen (3), wobei das Verpressen in einer von dem Substrat verschiedenen Form (7) erfolgt;
d) Einsetzen der Grünlinge in die Durchgangslöcher des Substrats, sodass innerhalb eines jeden Durchgangslochs entlang dessen Achse sich je ein Grünling durch das Substrat hindurch erstreckt;
e) Anordnen des Substrats mit den darin eingesetzten Grünlingen zwischen zwei im Wesentlichen ebenen Elektroden (12a, 12b), sodass beide Elektroden und das Substrat im Wesentlichen parallel zueinander ausgerichtet sind;
f) Kontaktieren der Stirnseiten der Grünlinge mit den Elektroden, sodass über die Grünlinge zwischen den beiden Elektroden eine Verbindung geschaffen wird, die sowohl einen elektrischen Strom, als auch einen mechanischen Kraftfluss überträgt;
g) Beaufschlagen der Grünlinge mit einem zwischen den Elektroden fließenden elektrischen Strom, sodass innerhalb des thermoelektrischen Aktivmaterials Wärme hervorgerufen wird;

h) Beaufschlagen der Grünlinge mit einer zwischen den Elektroden wirkenden Druckkraft, sodass das thermoelektrische Aktivmaterial unter Druck gerät;

i) Sintern der Grünlinge zu Thermoschenkeln unter Einwirkung des Drucks und der Wärme;

k) Planieren des Substrats und der darin aufgenommen Thermoschenkel durch Annähern der Elektroden unter Beibehaltung ihrer Parallelität, sodass die Thermoschenkel bündig mit dem Substrat abschließen, wobei etwaiger axialer Versatz der Grünlinge in dem Substrat sowie Sinterschwund ausgeglichen wird.

**2.** Verfahren nach Anspruch 1, **dadurch gekennzeichnet, dass** mehrere Substrate (1i, 1ii, 1iii) mit eingesetzten Grünlingen zu einem Stapel zusammengefasst werden, wobei sich die Substrate innerhalb des Stapels parallel zueinander erstrecken und jeweils zwischen zwei innerhalb des Stapels benachbarten Substraten eine im Wesentlichen ebene Trennplatte (18a, 18b) eingelegt ist, welche sich parallel zu den Substraten erstreckt und welche eine elektrisch leitfähige und Kraft übertragende Verbindung zwischen den Grünlingen der benachbarten Substrate herstellt, und dass der gesamte Stapel zwischen den beiden Elektroden angeordnet wird.

**3.** Verfahren nach Anspruch 1 oder 2, **dadurch gekennzeichnet, dass** mehrere Substrate mit eingesetzten Grünlingen einzeln bzw. gestapelt in einer Ebene zwischen den beiden Elektroden angeordnet werden.

**4.** Verfahren nach Anspruch 1 oder nach einem der Ansprüche 2 bis 3, wobei die Elektroden und/oder die Trennplatten aus Graphit bestehen, **dadurch gekennzeichnet, dass** die Grünlinge zum Kontaktieren mit einer ersten Druckkraft (F) beaufschlagt werden, dass dann die Grünlinge unter Einwirkung der ersten Druckkraft mit Strom beaufschlagt werden, bis die aus Graphit bestehenden Elektroden bzw. Trennplatten eine Temperatur erreicht haben, bei welcher die aus Graphit bestehenden Elektroden bzw. Trennplatten eine erhöhte Tragfähigkeit aufweisen, welche oberhalb der ersten Druckkraft liegt, und dass die Grünlinge sodann mit der zweiten Druckkraft beaufschlagt werden, welche oberhalb der ersten Druckkraft und unterhalb der erhöhten Tragfähigkeit liegt.

**5.** Verfahren nach Anspruch 1 oder einem der Ansprüche 2 bis 4, **dadurch gekennzeichnet, dass** beim Verpressen des pulverförmigen Aktivmaterials zu den Grünlingen das Aktivmaterial verdichtet wird auf eine erste Pressdichte, welche zwischen 75 % und 85 % der Reindichte des Aktivmaterials entspricht.

**6.** Verfahren nach Anspruch 1 oder einem der Ansprüche 2 bis 5, **dadurch gekennzeichnet, dass** das Sintern der Grünlinge zu den Thermoschenkeln bei einer Temperatur erfolgt, welche zwischen 50 % bis 70 % der Schmelztemperatur des Aktivmaterials entspricht.

**7.** Verfahren nach Anspruch 1 oder einem der Ansprüche 2 bis 6, **dadurch gekennzeichnet, dass** beim Beaufschlagen der Grünlinge mit der zwischen den Elektroden wirkenden Druckkraft die Grünlinge auf eine zweite Pressdichte verdichtet werden, welche zwischen 90 % und 97 % der Reindichte des Aktivmaterials entspricht.

**8.** Verfahren nach Anspruch 1 oder einem der Ansprüche 2 bis 7, **dadurch gekennzeichnet, dass** die Grünlinge eine kreiszylindrische Gestalt aufweisen.

**9.** Verfahren nach Anspruch 8, **dadurch gekennzeichnet, dass** die Grünlinge stirnseitig jeweils eine Fase aufweisen.

**10.** Verfahren nach Anspruch 8 oder 9, **dadurch gekennzeichnet, dass** die Grünlinge auf ihrer Mantelfläche einen gemäß DIN 4766 T2 bestimmten Mittenrauwert $R_a$ zwischen 12 $\mu$m und 24 $\mu$m aufweisen.

**11.** Verfahren nach Anspruch 1 oder einem der Ansprüche 2 bis 10, **dadurch gekennzeichnet, dass** die Grünlinge in die Durchgangslöcher eingeklemmt werden, wahlweise durch Verwendung kegelförmiger Grünlinge und/oder Durchgangslöcher oder durch ein radiales Übermaß der Grünlinge gegenüber den Durchgangslöchern.

**12.** Verfahren nach Anspruch 1 oder einem der Ansprüche 2 bis 11, **dadurch gekennzeichnet, dass** das pulverförmige thermoelektrische Aktivmaterial in einer Tablettenpresse (4) trocken bereitgestellt wird, dass die Form, in welcher das Aktivmaterial zu Grünlingen verpresst wird, innerhalb der Tablettenpresse angeordnet ist, und dass die Grünlinge von der Tablettenpresse ungeordnet ausgestoßen werden.

**13.** Verfahren nach Anspruch 12, **dadurch gekennzeichnet, dass** die Grünlinge manuell oder von einer Fördereinrichtung aufgenommen, vereinzelt und geordnet in die Durchgangslöcher des Substrats eingesetzt werden.

**14.** Verfahren nach Anspruch 1 oder einem der Ansprüche 2 bis 13, **dadurch gekennzeichnet, dass** es sich bei dem Substratmaterial um einen Verbundwerkstoff aus anorganischen Rohstoffen und Bindemitteln handelt.

15. Verfahren nach Anspruch 14, **dadurch gekennzeichnet, dass** der Verbundwerkstoff als Laminat aufgebaut ist, dass die organischen Rohstoffe ausgewählt sind aus der Gruppe umfassend Glimmer, Perlite, Phlogopite, Muscovite, und dass es sich bei dem Bindemittel um Silikon oder um Silikonharz oder um Epoxidharz handelt.

**Claims**

1. Method for production of a thermoelectric component or at least a semifinished version thereof, **characterized by** the following steps:

   a) providing a substantially planar substrate (1) made of an electrically and thermally insulating substrate material, through which through-holes (2) extend oriented substantially perpendicularly to the substrate plane;
   b) providing pulverulent thermoelectrically active active material (5);
   c) pressing the active material to form green bodies (3), wherein the pressing proceeds in a mould (7) different from the substrate;
   d) inserting the green bodies into the through-holes of the substrate in such a manner that, within each through-hole, along the axis thereof, one green body extends through the substrate;
   e) arranging the substrate with the green bodies inserted therein between two substantially planar electrodes (12a, 12b), in such a manner that both electrodes and the substrate are substantially orientated parallel to one another;
   f) contacting face ends of the green bodies with the electrodes in such a manner that a connection is provided between the two electrodes via the green bodies, which connection transmits not only an electrical current but also a mechanical pressing force;
   g) exposing the green bodies to an electric current flowing between the electrodes in such a manner that heat is evoked within the thermoelectric active material;
   h) exposing the green bodies to a pressure force acting between the electrodes in such a manner that the thermoelectric active material comes under pressure;
   i) sintering the green bodies to form thermolegs, with the action of pressure and heat;
   k) levelling the substrate and the thermolegs accommodated therein by bringing them closer to the electrodes while maintaining the parallelity thereof, in such a manner that thermolegs finish flush with the substrate, wherein any axial offset of the green bodies in the substrate and also any sinter shrinkage are compensated for.

2. Method according to Claim 1, **characterized in that** a plurality of substrates (1i, 1ii, 1iii) with inserted green bodies are combined to form a stack, wherein the substrates extend within the stack in parallel to one another and in each case a substantially planar separation plate (18a, 18b) is laid between two substrates that are adjacent within the stack, which separation plate extends in parallel to the substrates and which produces an electrically conductive and force-transmitting connection between the green bodies of the adjacent substrates, and **in that** the entire stack is arranged between the two electrodes.

3. Method according to Claim 1 or 2, **characterized in that** a plurality of substrates having inserted green bodies are arranged individually or stacked in a plane between the two electrodes.

4. Method according to Claim 1 or according to one of Claims 2 to 3, wherein the electrodes and/or the separation plates consist of graphite, **characterized in that** the green bodies, for contacting, are exposed to a first pressing force (F), **in that** then the green bodies under the action of the first pressing force are exposed to electric current until the electrodes and/or separation plates consisting of graphite have achieved a temperature at which the electrodes and/or separation plates consisting of graphite have an increased load-bearing capacity which is above the first pressing force, and **in that** the green bodies are then exposed to the second pressing force, which is above the first pressing force and below the increased load-bearing capacity.

5. Method according to Claim 1 or one of Claims 2 to 4, **characterized in that**, in the pressing of the pulverulent active material to form the green bodies, the active material is compacted to a first compressed density which corresponds to between 75% and 85% of the true density of the active material.

6. Method according to Claim 1 or one of Claims 2 to 5, **characterized in that** the green bodies are sintered to form the thermolegs at a temperature which corresponds to between 50% to 70% of the melting temperature of the active material.

7. Method according to Claim 1 or one of Claims 2 to 6, **characterized in that** during the exposure of the green bodies to the pressing force acting between the electrodes, the green bodies are compacted to a second compressed density which corresponds to between 90% and 97% of the true density of the active material.

8. Method according to Claim 1 or one of Claims 2 to 7, **characterized in that** the green bodies have a circular cylindrical shape.

9. Method according to Claim 8, **characterized in that** the green bodies each have a chamfer at the end face.

10. Method according to Claim 8 or 9, **characterized in that** the green bodies have a mean roughness value $R_a$ between 12 $\mu$m and 24 $\mu$m, as specified in DIN 4766 T2, on the lateral surface thereof.

11. Method according to Claim 1 or one of Claims 2 to 10, **characterized in that** the green bodies can be clamped into the through-holes, alternatively by using conical green bodies and/or through-holes or a radial oversize of the green bodies compared with the through-holes.

12. Method according to Claim 1 or one of Claims 2 to 11, **characterized in that** the pulverulent thermoelectric active material is prepared dry in a tableting press (4), **in that** the mould in which the active material is pressed to form green bodies is arranged within the tableting press, and **in that** the green bodies are ejected randomly from the tableting press.

13. Method according to Claim 12, **characterized in that** the green bodies, manually or by a conveying appliance, are taken up, isolated and inserted in an ordered manner into the through-holes of the substrate.

14. Method according to Claim 1 or one of Claims 2 to 13, **characterized in that**
the substrate material is a composite material made of inorganic raw materials and binders.

15. Method according to Claim 14, **characterized in that** the composite material is made up as a laminate, **in that** the organic raw materials are selected from the group consisting of mica, perlite, phlogopite, muscovite and **in that** the binder is silicone or silicone resin or epoxy resin.


## Revendications

1. Procédé de fabrication d'un composant thermoélectrique ou d'au moins un produit semi-fini de celui-ci, **caractérisé par** les étapes suivantes :

   a) la mise à disposition d'un substrat essentiellement plan (1) constitué par un matériau de substrat électriquement et thermiquement isolant, au travers duquel des trous traversants (2) orientés essentiellement à la perpendiculaire du plan du substrat s'étendent ;
   b) la mise à disposition d'un matériau actif en poudre thermoélectriquement actif (5) ;
   c) le pressage du matériau actif en ébauches crues (3), le pressage ayant lieu dans un moule (7) différent du substrat ;
   d) l'insertion des ébauches crues dans les trous traversants du substrat, de telle sorte qu'une ébauche crue s'étende au travers du substrat dans chaque trou traversant le long de son axe ;
   e) l'agencement du substrat avec les ébauches crues insérées dans celui-ci entre deux électrodes essentiellement planes (12a, 12b), de telle sorte que les deux électrodes et le substrat soient orientés essentiellement en parallèle les uns des autres ;
   f) la mise en contact des côtés frontaux des ébauches crues avec les électrodes, de manière à créer une connexion par le biais des ébauches crues entre les deux électrodes, qui transmet aussi bien un courant électrique qu'un flux de force mécanique ;
   g) le chargement des ébauches crues avec un courant électrique s'écoulant entre les électrodes, de manière à produire de la chaleur à l'intérieur du matériau actif thermoélectrique ;
   h) le chargement des ébauches crues avec une force de pression agissant entre les électrodes, de manière à mettre le matériau actif thermoélectrique sous pression ;
   i) le frittage des ébauches crues en branches thermiques sous l'effet de la pression et de la chaleur ;

k) l'aplanissement du substrat et des branches thermiques logées dans celui-ci par rapprochement des électrodes en maintenant leur parallélisme, de telle sorte que les branches thermiques finissent par former une surface plane avec le substrat, un éventuel décalage axial des ébauches crues dans le substrat et un retrait de frittage étant compensés.

2. Procédé selon la revendication 1, **caractérisé en ce que** plusieurs substrats (1i, 1ii, 1iii) comprenant des ébauches crues insérées sont rassemblés en une pile, les substrats dans la pile s'étendant en parallèle les uns des autres et une plaque de séparation essentiellement plane (18a, 18b) étant disposée à chaque fois entre deux substrat voisins dans la pile, qui s'étend en parallèle des substrats et qui crée une connexion électriquement conductrice et transmettant une force entre les ébauches crues des substrats voisins, et **en ce que** l'ensemble de la pile est agencée entre les deux électrodes.

3. Procédé selon la revendication 1 ou 2, **caractérisé en ce que** plusieurs substrats comprenant des ébauches crues insérées sont agencés individuellement ou empilés dans un plan entre les deux électrodes.

4. Procédé selon la revendication 1 ou selon l'une quelconque des revendications 2 à 3, dans lequel les électrodes et/ou les plaques de séparation sont constituées par du graphite, **caractérisé en ce que** les ébauches crues sont chargées avec une première force de pression (F) pour la mise en contact, **en ce que** les ébauches crues sont ensuite chargées avec un courant sous l'effet de la première force de pression, jusqu'à ce que les électrodes ou les plaques de séparation constituées par du graphite aient atteint une température à laquelle les électrodes ou les plaques de séparation constituées par du graphite présentent une capacité portante augmentée, qui est supérieure à la première force de pression, et **en ce que** les ébauches crues sont alors chargées avec la deuxième force de pression, qui est supérieure à la première force de pression et inférieure à la capacité portante augmentée.

5. Procédé selon la revendication 1 ou selon l'une quelconque des revendications 2 à 4, **caractérisé en ce que**, lors du pressage du matériau actif en poudre pour former les ébauches crues, le matériau actif est compacté à une première densité de pressage, qui est comprise entre 75 % et 85 % de la densité réelle du matériau actif.

6. Procédé selon la revendication 1 ou selon l'une quelconque des revendications 2 à 5, **caractérisé en ce que** le frittage des ébauches crues pour former les branches thermiques a lieu à une température qui est comprise entre 50 % et 70 % de la température de fusion du matériau actif.

7. Procédé selon la revendication 1 ou selon l'une quelconque des revendications 2 à 6, **caractérisé en ce que**, lors du chargement des ébauches crues avec la force de pression agissant entre les électrodes, les ébauches crues sont compactées à une deuxième densité de pressage, qui est comprise entre 90 % et 97 % de la densité réelle du matériau actif.

8. Procédé selon la revendication 1 ou selon l'une quelconque des revendications 2 à 7, **caractérisé en ce que** les ébauches crues présentent une configuration cylindrique creuse.

9. Procédé selon la revendication 8, **caractérisé en ce que** les ébauches crues présentent chacune un biseau sur le côté frontal.

10. Procédé selon la revendication 8 ou 9, **caractérisé en ce que** les ébauches crues présentent sur leur surface d'enveloppe une valeur de rugosité moyenne $R_a$ déterminée selon DIN 4766 T2 comprise entre 12 $\mu$m et 24 $\mu$m.

11. Procédé selon la revendication 1 ou selon l'une quelconque des revendications 2 à 10, **caractérisé en ce que** les ébauches crues sont coincées dans les trous traversants, éventuellement en utilisant des ébauches crues et/ou des trous traversants coniques ou par une surmesure radiale des ébauches crues par rapport aux trous traversants.

12. Procédé selon la revendication 1 ou selon l'une quelconque des revendications 2 à 11, **caractérisé en ce que** le matériau actif thermoélectrique en poudre est mis à disposition sous forme sèche dans une pastilleuse (4), **en ce que** le moule dans lequel le matériau actif est pressé en ébauches crues est agencé dans la pastilleuse, et **en ce que** les ébauches crues sont déchargées en désordre de la pastilleuse.

13. Procédé selon la revendication 12, **caractérisé en ce que** les ébauches crues sont insérées manuellement ou par un dispositif de transport, sous forme isolée et ordonnée, dans les trous traversants du substrat.

**14.** Procédé selon la revendication 1 ou selon l'une quelconque des revendications 2 à 13, **caractérisé en ce que** le matériau de substrat consiste en un matériau composite à base de matières premières inorganiques et de liants.

**15.** Procédé selon la revendication 14, **caractérisé en ce que** le matériau composite est configuré sous la forme d'un stratifié, **en ce que** les matières premières organiques sont choisies dans le groupe comprenant le mica, la perlite, le phlogopite, la muscovite, et **en ce que** le liant consiste en de la silicone ou une résine de silicone ou une résine époxyde.

Fig. 1

Fig. 2a          Fig. 2b          Fig. 2c

Fig. 2d          Fig. 2e          Fig. 2f

Fig. 3

y

Fig. 4

Fig. 5

Fig. 6

Fig. 7

Fig. 8

Fig. 9

Fig. 10

Fig. 11

**EP 3 196 951 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008061823 A1
- DE 102012205087 A1
- WO 2015043824 A1
- US 6297441 B1